# EUROPÄISCHE PATENTANMELDUNG

(11) **EP 2 280 484 A1**
(43) Veröffentlichungstag der Anmeldung: **02.02.2011**
(21) Anmeldenummer: 10170631.5
(22) Anmeldetag: 23.07.2010
(51) Int. Cl.: H03K 17/96, F16F 1/36

(54) **Sensorelementeinrichtung**

(30) Priorität: 28.07.2009 DE 102009036162
(71) Anmelder: E.G.O. Elektro-Gerätebau GmbH, 75038 Oberderdingen (DE)
(72) Erfinder: Dombrowski, Holger, 74613, Oehringen (DE); Fix, Thorsten, 75177, Pforzheim (DE)
(74) Vertreter: Patentanwälte Ruff, Wilhelm, Beier, Dauster & Partner

(57) **Zusammenfassung**

Eine Sensorelementeinrichtung für einen kapazitiven Näherungsschalter einer Bedieneinrichtung weist eine Oberseite auf zur Anlage an der Unterseite eines Bedienfeldes der Bedieneinrichtung und eine blockartige Leuchtanzeige mit Leuchtrichtung zur Unterseite des Bedienfeldes. Die Leuchtanzeige als Sensorelementeinrichtung ist an ihrer zum Bedienfeld hin weisenden Seite bzw. Oberseite elektrisch leitfähig und bildet so ein Sensorelement. Die Leuchtanzeige ist mittels einer voluminösen, raumformveränderlichen, elastischen und elektrisch leitfähigen Materialschicht auf einem Bauteilträger gelagert, wobei diese Materialschicht den erforderlichen variablen Abstand sowie die elektrische Verbindung von der Oberseite zur Unterseite als Kontaktierung aufweist.

## Beschreibung

### Anwendungsgebiet und Stand der Technik

Die Erfindung betrifft eine Sensorelementeinrichtung für einen kapazitiven Näherungsschalter einer Bedieneinrichtung.

Aus der EP 859 467 A ist eine Sensorelementeinrichtung bekannt mit einem voluminösen und raumformveränderlichen Kunststoffkörper in Zylinderform, der eine Ausnehmung in Längsrichtung aufweist. An der Oberseite ist eine Kunststoffscheibe vorgesehen, die eine Lichtdurchlässigkeit in Symbolform aufweist, beispielsweise als längliches Rechteck. Eine in dem Kunststoffkörper in der Ausnehmung vorgesehene LED bewirkt also eine beleuchtete Symboldarstellung. Die Oberseite des elastischen Kunststoffkörpers als breiter Kreisring bildet ein kapazitives Sensorelement der kapazitiven Näherungsschalteinrichtung.

Des Weiteren ist es aus der EP 1 030 536 A1 bekannt, über eine Leuchtanzeige als Sieben-Segment-Anzeige einen umlaufenden Metallrahmen vorzusehen. Dieser verläuft mit Abstützung seitlich an der Leuchtanzeige vorbei und ermöglicht es so, sozusagen einen kapazitiven Näherungsschalter über einer Leuchtanzeige zu schaffen. Wird ein Finger also auf die Leuchtanzeige gelegt, insbesondere mit einem Bedienfeld dazwischen, kann dies der kapazitive Näherungsschalter erkennen und eine Schaltfunktion auslösen.

### Aufgabe und Lösung

Der Erfindung liegt die Aufgabe zugrunde, eine eingangs genannte Sensorelementeinrichtung für einen kapazitiven Näherungsschalter mit Leuchtanzeige zu schaffen, mit der Probleme des Standes der Technik beseitigt werden können und insbesondere eine vorteilhafte Kombination von kapazitivem Näherungsschalter und Leuchtanzeige möglich ist.

Gelöst wird diese Aufgabe durch eine Sensorelementeinrichtung mit den Merkmalen des Anspruchs 1. Vorteilhafte und bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Es ist vorgesehen, dass die Sensorelementeinrichtung eine Oberseite aufweist zur Anlage an der Unterseite eines Bedienfeldes der Bedieneinrichtung. Ebenso weist sie eine Leuchtanzeige mit einem Rahmenkörper auf, insbesondere einen Leuchtkörper mit Rahmen, mit einer Leuchtrichtung zur Unterseite des Bedienfeldes. Erfindungsgemäß ist die Leuchtanzeige als Sensorelementeinrichtung ausgebildet bzw. bildet die Sensorelementeinrichtung, wozu sie mindestens an ihrer zum Bedienfeld hin weisenden Seite bzw. ihrer Oberseite elektrisch leitfähig ist und so ein flächiges Sensorelement für den kapazitiven Näherungsschalter bildet. Dieses Sensorelement liegt dann an der Unterseite des Bedienfeldes an, ähnlich wie es beispielsweise bei der vorgenannten EP 1 030 536 A1 der umlaufende Metallrahmen tut. Des Weiteren ist die Leuchtanzeige auf einem Bauteilträger gelagert, und zwar mittels einer voluminösen, raumformveränderlichen und/oder elastischen Schicht aus elektrisch leitfähigem Material. Diese Materialschicht bildet also als eine erste Funktion eine elastische bzw. flexible Andrückung der Leuchtanzeige und somit des Sensorelements an die Unterseite des Bedienfelds. Des Weiteren weist die Leuchtanzeige eine elektrisch leitfähige Verbindung von ihrer Oberseite zu ihrer Unterseite auf, als Kontaktierung an die Materialschicht. Über diese Materialschicht ist sie also als zweite Funktion an einen elektrischen Anschluss an dem Bauteilträger verbunden, der an eine Ansteuerung und/oder Auswertung bzw. allgemein eine Ansteuerung gehen kann.

Somit erfüllt die Materialschicht für die Sensorelementeinrichtung zwei Funktionen, nämlich zum einen das flexible Andrücken des Sensorelements an die Unterseite des Bedienfelds für elektrisch und technisch gut beherrschbare und definierte Bedingungen. Des Weiteren bildet die Materialschicht zumindest einen Teil der elektrischen Kontaktierung bzw. des elektrischen Anschlusses an das Sensorelement, vorzugsweise den gesamten elektrischen Anschluss.

In Ausgestaltung der Erfindung kann das Sensorelement an der Oberseite der Leuchtanzeige mindestens umlaufend und rahmenartig ausgebildet sein, möglicherweise auch vollflächig. Bei einer ausreichend breiten Ausführung mit wenigen Millimetern Rahmenbreite reicht dies für einen kapazitiven Näherungsschalter. Vorteilhaft kann das Sensorelement gemäß einer Ausbildung der Erfindung die gesamte Oberfläche der Leuchtanzeige bedecken bzw. von der gesamten Oberfläche der Leuchtanzeige gebildet werden. Dafür gibt es mehrere Möglichkeiten, wie nachfolgend noch beschrieben wird. Selbstverständlich ist dann eben vorzusehen, dass, wenn die Leuchtanzeige möglicherweise im mittleren Bereich lichtdurchlässig sein soll oder Licht abstrahlen soll, das Sensorelement diese Lichtabstrahlung nicht negativ beeinträchtigt.

In alternativer Ausgestaltung der Erfindung kann das Sensorelement ebenfalls umlaufend rahmenartig ausgebildet sein mit einer Ausnehmung, die vorteilhaft mittig angeordnet ist. Die Ausnehmung kann entweder, vor allem bei einem diffusen Lichtleitermaterial, kleiner sein als ein Anzeigesymbol der Leuchtanzeige. Vorteilhaft ist sie mindestens so groß wie ein Anzeigesymbol der Leuchtanzeige. So kann das Sensorelement problemlos lichtundurchlässig ausgebildet sein bzw. eine Lichtdurchlässigkeit ist nicht mehr zwingend vorzusehen.

Vorteilhaft liegt das Sensorelement für eine möglichst gute Funktion als kapazitiver Näherungsschalter flächig an der Unterseite des Bedienfeldes an. Insbesondere liegt es mit seiner gesamten Fläche an, also im Falle einer rahmenartigen Ausbildung mit dieser Rahmenfläche, alternativ mit einer gesamten Fläche.

In einer Ausgestaltung der Erfindung kann die elektrisch leitfähige Verbindung von dem Sensorelement an der Oberseite der Leuchtanzeige zu der Unterseite ein Leitlack sein, also ein elektrisch leitfähiger Lack, alternativ eine elektrisch leitfähige Beschichtung. Bei dieser können oben Flächen auf der Leuchtanzeige, zumindest in der Form des vorbeschriebenen Sensorelements, vorgesehen sein, also dort, wo die Oberseite der Leuchtanzeige bzw. das Sensorelement an der Unterseite des Bedienfelds anliegt. Der Leitlack kann sich am Rand an der Leuchtanzeige zu deren unterem Bereich bzw. zu ihrer Unterseite erstrecken, also bis zu einer Kontaktfläche bzw. Berührfläche mit der Materialschicht. So erfolgt also die elektrische Kontaktierung.

In Weiterbildung der Erfindung kann ein vorbeschriebener Leitlack lichtdurchlässig sein, vorteilhaft im Wesentlichen transparent. Dann kann er im Wesentlichen auch die gesamte Oberfläche der Leuchtanzeige bedecken, wie es vorstehend bereits beschrieben worden ist.

Alternativ kann der Leitlack lichtundurchlässig sein, beispielsweise ein Silberlack sein. Dann kann er, wie vorbeschrieben, einen umlaufenden rahmenartigen Bereich der Oberseite der Leuchtanzeige bedecken und den leuchtenden Bereich in der Mitte freilassen. Eine Lichtundurchlässigkeit an der Seite der Leuchtanzeige ist nicht störend, da hier ganz üblicherweise ohnehin kein Leuchten gewünscht ist. Möglicherweise kann allein durch einen solch lichtundurchlässigen Leitlack sogar ein seitliches Leuchten unterbunden werden, beispielsweise wenn das Material des gesamten Körpers lichtdurchlässig ist. Das Aufbringen eines solchen Leitlacks kann beispielsweise durch Tauchen, Sprühen oder Bedrucken erfolgen. Ein Entfernen des lichtundurchlässigen Leitlacks in der Form des anzuzeigenden Leuchtsymbols kann beispielsweise entsprechend der DE 10 2004 040 998 A1 erfolgen oder entsprechend der DE 10 2009 036 161 A1, auf die diesbezüglich explizit verwiesen wird. Vor allem ein Entfernen mit Laser wird als vorteilhaft angesehen.

Alternativ zu dem Vorsehen eines Leitlacks sowohl als Sensorelement als auch als elektrische Verbindung von diesem Sensorelement zu einer Materialschicht kann vorgesehen sein, die Leuchtanzeige selbst zumindest teilweise aus elektrisch leitfähigem Material zu fertigen, vorteilhaft ganz. Dieses Material kann dann sowohl das Sensorelement an der Oberseite der Leuchtanzeige bilden als auch die beschriebene elektrisch leitfähige Verbindung an die Materialschicht. Dies kann vorteilhaft als umlaufender Rahmenabschnitt aus elektrisch leitfähigem Kunststoff sein, der einen Lichtleitkörper aus lichtdurchlässigem Material umgibt. Dieser Lichtleitkörper kann beispielsweise auch schon in Symbolform für die gewünschte Leuchtanzeige ausgebildet sein. Ein solcher Lichtleitkörper braucht nicht elektrisch leitfähig zu sein, da ein rahmenartig ausgebildetes Sensorelement für den kapazitiven Näherungsschalter als ausreichend angesehen wird und so der Aufwand für den lichtdurchlässigen Kunststoff geringer bleibt. Möglicherweise kann auch auf einen solchen Lichtleitkörper ganz verzichtet werden und lediglich eine entsprechende Ausnehmung bzw. ein Durchbruch als Lichtdurchtritt vorgesehen sein. Der elektrisch leitfähige Kunststoff der Leuchtanzeige bildet somit mit seiner Oberseite das kapazitive Sensorelement und mit seiner Unterseite bzw. seinem unteren Bereich die elektrische Kontaktierung an die Materialschicht. Somit kann das aufwändige Aufbringen eines Leitlacks entfallen.

Alternativ zu einem Leitlack an der Oberseite der Leuchtanzeige als kapazitives Sensorelement könnte eine alternative elektrisch leitfähige Beschichtung aufgebracht werden, möglicherweise sogar als metallische Beschichtung bzw. auch als dünnes Metallblech oder dünne Metallfolie. Diese werden dann vorteilhaft aufgeklebt um Montageprobleme zu vermeiden, wobei für die Verklebung wiederum ein elektrisch leitfähiger Kleber von Vorteil sein kann. In nochmals weitere Ausgestaltung der Erfindung kann die Leuchtanzeige aus einem elektrisch leitfähigen Metallteil mit Ausnehmung in Symbolform bestehen, beispielsweise aus dickem Blech als Stanzteil.

Der Rahmenkörper bzw. die Leuchtanzeige als Funktionseinheit können blockartig bzw. quaderartig ausgebildet sein. Die Form bzw. vor allem die Ausbildung der Oberseite für das Sensorelement kann auch rund bzw. oval, dreieckig oder vieleckig sein.

Die Leuchtanzeige kann beispielsweise als Sieben-Segment-Anzeige ausgebildet sein mit einem Rahmenkörper und entsprechenden Lichtleitkörpern aus lichtdurchlässigem Material bzw. Lichtdurchtritten, vorteilhaft sieben. Dann ist auch für jeden Lichtleitkörper eine Lichtquelle bzw. ein Leuchtmittel vorgesehen. Das Material zwischen den Lichtdurchtritten ist vorteilhaft das gleiche wie das des Rahmenkörpers.

In Weiterbildung der Erfindung wird die Leuchtanzeige nicht nur einfach auf die Materialschicht aufgesetzt und möglicherweise durch Formschluss befestigt bzw. positioniert, sondern es kann eine elektrisch leitfähige Verklebung vorgesehen sein. Dadurch können Leuchtanzeige und Materialschicht ein einziges Bauteil bilden bei vorheriger Verklebung, welches dann leicht auf den Bauteilträger aufgesetzt werden kann. In ähnlicher Form kann auch die Materialschicht mit einer elektrisch leitfähigen Verklebung auf dem Bauteilträger befestigt werden.

Die Materialschicht kann vorteilhaft aus elektrisch leitfähigem und geschäumtem Kunststoff bestehen, der beispielsweise in der vorgenannten EP 859 467 A2 beschrieben ist. Eine Höhe der Materialschicht kann wenige Millimeter betragen, vorzugsweise zwischen 1 mm und 5 mm. Insbesondere kann sie zwischen 3 mm und 4 mm liegen und so für einen ausreichenden Federweg von 1 mm oder 2 mm sorgen.

Vorteilhaft weist die Materialschicht einen Ausschnitt auf, um darin ein Leuchtmittel für die Leuchtanzeige anzuordnen. Dies ist besonders vorteilhaft eine LED. Ein solcher Ausschnitt kann mittig vorgesehen sein, so dass die Materialschicht rahmenartig umlaufend ausgebildet sein kann. Sie kann zur Seite hin lichtundurchlässig sein, wodurch unerwünschte Lichterscheinungen zur Seite hin bzw. nach außen, also nicht nur an der Oberseite der Leuchtanzeige, vermieden werden können.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine Draufsicht auf eine erfindungsgemäße Sensorelementein- richtung in schräger Ansicht mit einer Leuchtanzeige samt Symbol, die auf einer elastischen Materialschicht befestigt ist,
- Fig. 2: die Sensorelementeinrichtung aus Fig. 1 in schräger Ansicht der Unterseite,
- Fig. 3: die Sensorelementeinrichtung aus Fig. 1 im Einbauzustand in einer Bedieneinrichtung zwischen Bauteilträger und Bedienfeld und
- Fig. 4: einen Schnitt durch eine etwas abgewandelte Sensorelement- einrichtung ähnlich Fig. 1.

### Detaillierte Beschreibung der Ausführungsbeispiele

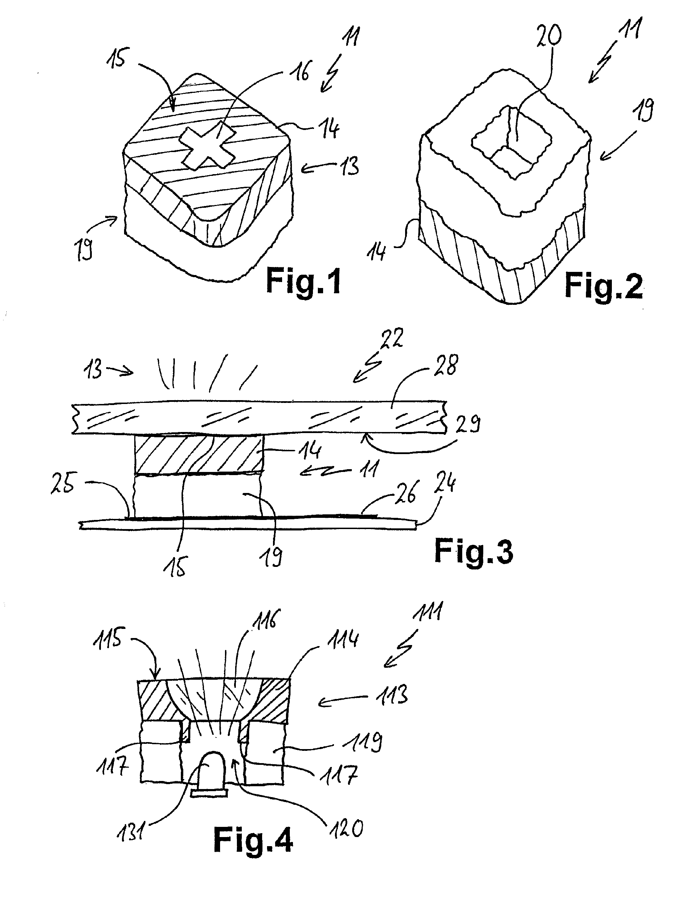

In Fig. 1 ist in schräger Draufsicht eine Sensorelementeinrichtung 11 dargestellt, die eine blockartige bzw. quaderartige Leuchtanzeige 13 aufweist aus Kunststoff. Die Leuchtanzeige 13 besteht aus einem Rahmenkörper 14, der aus lichtundurchlässigem Kunststoff besteht. Anstelle von Kunststoff kann auch ein leitfähiges Metallteil verwendet werden. In den Rahmenkörper 14 ist ein Lichtleitkörper 16 in Symbolform eingespritzt zur Darstellung eines Plus-Zeichens. Dies ist in Zwei-Komponenten-Spritzweise leicht möglich. Alternativ zu einem Lichtleitkörper kann auch das gesamte Teil aus lichtdurchlässigem Kunststoff bestehen und an der Oberseite zur Erzeugung des Symbols ein lichtundurchlässiger Lack mit der Symbolaussparung aufgebracht werden.

Wie durch die Schraffierung des Rahmenkörpers 14 dargestellt ist, ist dieser mit einem elektrisch leitfähigen Leitlack überzogen, insbesondere an der Oberseite 15 sowie den sonstigen Seiten und der Unterseite. Ein solcher Leitlack kann entweder als vorbeschriebener Silberlack ausgebildet sein und lichtundurchlässig sein, wobei er dann den Lichtleitkörper 16 bzw. das Symbol ausspart. Ist er lichtdurchlässig ausgebildet, so kann die gesamte Oberseite 15, und zwar auch über dem Lichtleitkörper 16, damit lackiert bzw. beschichtet sein.

Die Leuchtanzeige 13 ist auf einer dicken Materialschicht 19 befestigt, die sehr dick bzw. nahezu blockartig ist und aus vorgenanntem Material besteht. Deren Ausbildung ist auch aus der Ansicht in Fig. 2 zu ersehen. Die Materialschicht 19 weist eine mittige Ausnehmung 20 auf, die komplett durch sie hindurchgeht. Darin kann, wie nachfolgend noch näher erläutert wird, ein Leuchtmittel bzw. eine LED angeordnet sein, die von unten in den Lichtleitkörper 16 einstrahlt und so mit dessen Symbolform leuchtet. Eine Verbindung von Leuchtanzeige 13 und Materialschicht 19 kann durch elektrisch leitfähigen Kleber erfolgen. Dadurch ist sowohl eine elektrische Kontaktierung möglich als auch die mechanische Verbindung der beiden Teile zu einer Baueinheit.

In Fig. 3 ist eine Bedieneinrichtung 22 dargestellt, bei der eine Sensorelementeinrichtung 11 entsprechend Fig. 1 und 2 eingebaut ist. Auf einem Bauteilträger 24, vorteilhaft einer üblichen Leiterplatte, ist ein großes Kontaktfeld 25 mit Zuleitung 26 vorgesehen. Darauf ist die Sensorelementeinrichtung 11 mit einer Unterseite der Materialschicht 19 aufgesetzt und wird mechanisch gehalten. Vorteilhaft ist sie mit leitfähigem Kleber aufgeklebt.

Die Leuchtanzeige 13 bzw. die Sensorelementeinrichtung 11 liegt mit der Oberseite 15 an einer Unterseite 29 des Bedienfelds 28 an. Dabei bildet die in Fig. 1 schraffiert dargestellte Oberseite 15 ein kapazitives Sensorelement mit großer Fläche, welches wie bei einem kapazitiven Näherungsschalter üblich somit an der Unterseite 29 anliegt. Dieses Sensorelement der Oberseite 15 ist über die elektrisch leitfähige Beschichtung über die Seiten des Rahmenkörpers 14 an dessen Unterseite geführt und dort wiederum an die elektrisch leitfähige Materialschicht 19 verbunden. Diese wiederum ist durch die Verbindung mit dem Kontaktfeld 25 und die Zuleitung 26 an eine Steuerung angeschlossen. Somit ist also ein flächiges Sensorelement als Oberseite 15 an der Unterseite 29 des Bedienfelds 28 erreicht. Dieses arbeitet wie üblich durch Erkennen des Auflegens eines Fingers einer Bedienperson oberhalb der Sensorelementeinrichtung 11 bzw. der Oberseite 15.

Es ist also mit der Erfindung möglich, durch die federelastischen bzw. elastischen, nachgiebigen Eigenschaften der Materialschicht 19 die Leuchtanzeige 13 mit dem Sensorelement als Oberseite 15 stets an die Unterseite 29 des Bedienfelds 28 anzudrücken. So können sowohl mögliche Bewegungen als auch Höhentoleranzen oder Montagetoleranzen ausgeglichen werden. Es liegt stets eine definierte Anlage der Oberseite 15 an der Unterseite 29 vor. Des Weiteren kann durch die elektrisch leitfähige Beschichtung sowie die elektrisch leitfähige Materialschicht 19 ein Anschluss an das Sensorelement als Oberseite 15 erfolgen.

Eine alternative Ausbildung der Sensorelementeinrichtung 11 ist in Fig. 4 dargestellt. Hier ist keine elektrisch leitfähige Beschichtung der Leuchtanzeige 113 vorgesehen, der Rahmenkörper 114 besteht aus elektrisch leitfähigem Kunststoff. Er muss ja auch nicht lichtdurchlässig ausgebildet sein bzw. soll extra nicht lichtdurchlässig sein. Er schließt einen Lichtleitkörper 116 ein, der aber nicht elektrisch leitfähig sein muss. Eine Oberseite 115 des Rahmenkörpers 114 reicht als umlaufende Fläche, um wiederum ein kapazitives Sensorelement zu bilden.

Die Leuchtanzeige 113 sitzt mit einer Unterseite des Rahmenkörpers 114 auf einer Oberseite einer Materialschicht 119 auf. Diese ist wiederum entsprechend der vorherigen Figuren ausgebildet, also elektrisch leitfähig und elastisch. Allerdings weist hier der Rahmenkörper 114 zur Verbesserung des Zusammenhalts zwischen den beiden Teilen einen an der Unterseite abstehenden, ringartigen Flansch 117 auf, der von oben in eine mittige Ausnehmung 120 der Materialschicht 119 eingreift. So wird eine genaue Zentrierung bzw. Zuordnung vorgegeben. Des Weiteren wird eine gewisse Haltewirkung erreicht. Möglicherweise kann also auf ein Verkleben der beiden Teile verzichtet werden, wobei dies sowohl für eine mechanische Halterung als auch eine elektrisch leitfähige Verbindung mittels Leitkleber als vorteilhaft angesehen wird.

Des Weiteren ist in Fig. 4 auch eine LED 131 als Leuchtmittel dargestellt, die in die mittige Ausnehmung 120 hineinreicht und von unten in den Lichtleitkörper 116 hineinstrahlt und oben mit dessen Symbolform oder einer beliebigen Form herausstrahlt. Eine solche LED kann auch bei der Bedieneinrichtung 22 gemäß Fig. 3 in der Mitte des Kontaktfelds 25 vorgesehen sein, und über Durchkontaktierungen innerhalb der Fläche des Kontaktfelds 25 können elektrischen LED-Anschlüssen angeschlossen werden.

Ein Vorteil bei der Verarbeitung bzw. Herstellung der Bedieneinrichtung liegt also darin, dass die Leuchtanzeige mit der Materialschicht aus dem genannten Kunststoff zusammen vorher als Baueinheit bzw. als Sensorelementeinrichtung hergestellt werden kann. Eine Bestückung ist so sehr leicht möglich. Beispielsweise ist an der Unterseite der Materialschicht nach Verbinden der beiden Teile zu einer Baueinheit ein Klebeband vorgesehen, welches eine elektrische Leitfähigkeit bewirkt. Somit kann die Baueinheit mit einem SMD-Automaten bestückt werden auf Bauteilträger bzw. Leiterplatten. Des Weiteren kann so eine höhere Bauteildichte erreicht werden, da im Vergleich zu beispielsweise aus der EP 1 030 536 A bekannten Lösungen keine Sensorelementeinrichtungen notwendig sind, die seitlich größer sind als die Leuchtanzeige selbst.

## Patentansprüche

1. Sensorelementeinrichtung für einen kapazitiven Näherungsschalter einer Bedieneinrichtung, wobei die Sensorelementeinrichtung eine Oberseite aufweist zur Anlage an der Unterseite eines Bedienfeldes der Bedieneinrichtung und eine Leuchtanzeige mit einem Rahmenkörper aufweist mit Leuchtrichtung zur Unterseite des Bedienfeldes, **dadurch gekennzeichnet, dass** die Leuchtanzeige als Sensorelementeinrichtung mindestens an ihrer zum Bedienfeld hin weisenden Seite bzw. Oberseite elektrisch leitfähig ist und so ein Sensorelement bildet zur Anlage an der Unterseite des Bedienfelds, wobei die Leuchtanzeige mittels einer voluminösen, raumformveränderlichen und elektrisch leitfähigen Materialschicht auf einem Bauteilträger gelagert ist, wobei die Leuchtanzeige eine elektrisch leitfähige Verbindung von der Oberseite zu ihrer Unterseite aufweist als Kontaktierung an die Materialschicht und über diese an einen elektrischen Anschluss am Bauteilträger an eine Ansteuerung.

2. Sensorelementeinrichtung nach Anspruch 1, **dadurch gekennzeichnet, dass** das Sensorelement an der Oberseite der Leuchtanzeige mindestens umlaufend rahmenartig ausgebildet ist, vorzugsweise die gesamte Oberfläche der Leuchtanzeige bedeckt.

3. Sensorelementeinrichtung nach Anspruch 1, **dadurch gekennzeichnet, dass** das Sensorelement eine Ausnehmung aufweist, vorzugsweise in etwa in der Größe eines Anzeigesymbols der Leuchtanzeige.

4. Sensorelementeinrichtung nach einem der vorhergehenden Ansprüche, **dadurch gekennzeichnet, dass** das Sensorelement flächig, insbesondere mit seiner gesamten Fläche, an der Unterseite des Bedienfelds anliegt.

5. Sensorelementeinrichtung nach einem der vorhergehenden Ansprüche, **dadurch gekennzeichnet, dass** die elektrisch leitfähige Verbindung ein Leitlack ist, der oben flächig auf der Leuchtanzeige zumindest im Bereich der Anlage eines Teils des Sensorelements an der Unterseite des Bedienfelds vorgesehen ist und am Rand an der Leuchtanzeige zu deren unterem Bereich bzw. zur Unterseite und somit zur Materialschicht verläuft.

6. Sensorelementeinrichtung nach Anspruch 5, **dadurch gekennzeichnet, dass** der Leitlack lichtdurchlässig ist, insbesondere im wesentlichen transparent, wobei er vorzugsweise im wesentlichen die gesamte Oberseite der Leuchtanzeige bedeckt.

7. Sensorelementeinrichtung nach Anspruch 5, **dadurch gekennzeichnet, dass** der Leitlack lichtundurchlässig ist, insbesondere ein Silberlack ist, wobei er vorzugsweise im wesentlichen einen umlaufenden rahmenartigen Bereich der Oberseite der Leuchtanzeige bedeckt.

8. Sensorelementeinrichtung nach einem der Ansprüche 1 bis 4, **dadurch gekennzeichnet, dass** die Leuchtanzeige zumindest teilweise aus elektrisch leitfähigem Material besteht und sowohl das Sensorelement an der Oberseite der Leuchtanzeige als auch die elektrisch leitfähige Verbindung an die Materialschicht bildet, insbesondere mit einem umlaufenden Rahmenabschnitt aus lichtundurchlässigem Material, der einen Lichtleitkörper aus lichtdurchlässigem Material bzw. einen Lichtdurchtritt als Durchbruch umgibt, wobei vorzugsweise das elektrisch leitfähige Material elektrisch leitfähiger Kunststoff ist.

9. Sensorelementeinrichtung nach einem der vorhergehenden Ansprüche, **dadurch gekennzeichnet, dass** die Leuchtanzeige bzw. der Rahmenkörper blockartig bzw. quaderartig ausgebildet ist.

10. Sensorelementeinrichtung nach einem der vorhergehenden Ansprüche, **dadurch gekennzeichnet, dass** die Leuchtanzeige als Sieben-Segment-Anzeige ausgebildet ist mit einem Rahmenkörper und Lichtleitkörpern aus lichtdurchlässigem Material bzw. Lichtdurchtritten.

11. Sensorelementeinrichtung nach einem der vorhergehenden Ansprüche, **dadurch gekennzeichnet, dass** die Leuchtanzeige an der Materialschicht befestigt ist, insbesondere mittels einer elektrisch leitfähigen Verklebung.

12. Sensorelementeinrichtung nach einem der vorhergehenden Ansprüche, **dadurch gekennzeichnet, dass** die Materialschicht aus elektrisch leitfähigem geschäumtem flexiblem Kunststoff besteht.

13. Sensorelementeinrichtung nach einem der vorhergehenden Ansprüche, **dadurch gekennzeichnet, dass** die Materialschicht einen insbesondere mittigen Ausschnitt aufweist zur Anordnung eines Leuchtmittels darin für die Leuchtanzeige, wobei vorzugsweise die Materialschicht umlaufend rahmenartig ausgebildet ist und insbesondere lichtundurchlässig ist zur Seite hin.
